# EUROPEAN PATENT APPLICATION

(11) **EP 1 365 454 A1**
(43) Date of publication of application: **26.11.2003**
(21) Application number: 02710390.2
(22) Date of filing: 30.01.2002
(51) Int. Cl.: H01L 31/068

(54) **METHOD FOR PRODUCING SOLAR CELL AND SOLAR CELL**

(30) Priority: 31.01.2001 JP 2001024239; 28.02.2001 JP 2001054544
(71) Applicant: Shin-Etsu Handotai Co., Ltd, Tokyo 100-0005 (JP); Shin-Etsu Chemical Company, Ltd., Tokyo 100-0004 (JP)
(72) Inventor: TAKAHASHI, Masatoshi, SHIN-ETSU HANDOTAI CO., LTD., Annaka-shi, Gunma 379-0196 (JP); OHTSUKA, Hiroyuki, SHIN-ETSU HANDOTAI CO., LTD., Annaka-shi, Gunma 379-0196 (JP); OJIMA, Satoyuki, SHIN-ETSU HANDOTAI CO., LTD., Annaka-shi, Gunma 379-0196 (JP); WATABE, Takenori, SHIN-ETSU HANDOTAI CO., LTD., Annaka-shi, Gunma 379-0196 (JP); ABE, Takao, SHIN-ETSU HANDOTAI CO., LTD., Annaka-shi, Gunma 379-0196 (JP)
(74) Representative: Wagner, Bernhard Peter
(86) International application number: JP0200701
(87) International publication number: WO02061850

(57) **Abstract**

A plurality of nearly-parallel grooves 2 are formed on a first main surface 24a of a semiconductor single crystal substrate 24, and a metal electrode 6 for extracting cell is formed on the inner side face of each groove 2, which is used as an electrode-forming area, on one side as viewed in the width-wise direction of the groove. After a metal-containing underlying layer 49 is formed on the electrode-forming area, a main electrode metal layer 50 containing at least any one of an electroless-plated layer, electroplated layer and hot-dipped layer is formed on the metal-containing underlying layer 49.

## Description

### TECHNICAL FIELD

This invention relates to a solar cell and a method of fabricating the solar cell.

### BACKGROUND ART

Electrodes attached on the light-receiving surface of solar cells tend to prevent incident light from entering the solar cells to thereby cause shadowing loss and degrade the energy conversion efficiency, therefore various improvement efforts have been made on arrangement of the electrodes, pattern width and so forth. Known methods of forming the electrodes include screen printing using Ag paste, metal deposition through a mask, and electroplating or vacuum deposition through a patterned resist, where screen printing is generally used from an economical viewpoint. The electrode formation by screen printing, however, suffers from a limitation that the pattern width of the electrodes can be thinned only to as wide as 100 µm or around, and the shadowing loss can be reduced only to as low as 7 to 8% or around at present. Therefore it has long been considered that any improvement beyond the aforementioned limit might be difficult.

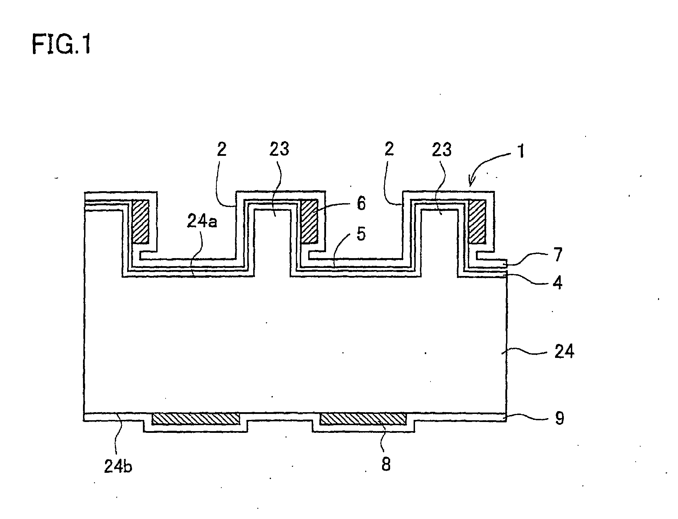

In recent years, the OECO (Obliquely Evaporated Contact) process attracts public attention because it can pattern finer electrode than by screen printing at low costs. The OECO process is a method of fabricating solar cells proposed by R. Hezel *et al.* of Institut für Solarenergieforschung Hameln/Emmerthal (ISFH), Germany, and is disclosed for example in *Renewable Energy,* Vol. 14, p.83 (1998) (solar cells fabricated by the OECO process will be referred to as OECO solar cells, hereinafter). A representative structure of a light-receiving surface of the OECO solar cell is schematically shown in Fig. 1. The OECO solar cell is configured so that a plurality of parallel grooves are formed on the main surface of a silicon single crystal substrate, which will serve as the light-receiving surface later, and so that electrodes 6 for extracting output are formed on the inner side faces of the individual grooves on a single side as viewed along the width-wise direction of the grooves. This constitution successfully reduced the shadowing loss of the solar cell to as small as approx. 5% of the total light-receiving area. Because a typical solar cell having the electrodes formed by the screen printing method generally suffers from a shadowing loss of as large as approx. 12%, it is understood that the OECO solar cell has a sharply reduced shadowing loss, and that a large energy conversion efficiency is attainable.

The conventional method of fabricating the OECO solar cell has, however, been improved only to a certain limited degree despite extensive efforts for improving the productivity, because the entire portion of the electrodes has been formed by vapor deposition and this consequently needed a considerably long time for deposition in order to obtain a thickness which can ensure a sufficiently low resistivity. It is also disadvantageous that an effort for increasing thickness of the electrode by the deposition process inevitably allows a lot of metal to deposit also on the top surface of projected ridges (reference numeral of 23 in Fig. 1) between the grooves, and in that the thus-deposited thick metal layer tends to have a large residual stress which may easily degrade adhesiveness of the layer. It is still also disadvantageous that the deposition continued for a long time will cause a large amount of metal adhesion or deposition in a deposition apparatus, and that this accordingly shortens the cleaning cycle of the apparatus.

It is therefore a subject of this invention to provide a method of fabricating a solar cell, capable of effectively reducing the shadowing loss by adopting a structure similar to that of the OECO solar cell, and capable of ensuring operation at a lower cost and of simplifying the maintenance of the apparatus as compared with vapor deposition, and to provide thus-fabricated solar cell, and more specifically to provide a solar cell capable of ensuring a sufficient level of adhesiveness of the metal electrodes for output extraction despite of their large thickness, and of effectively reducing resistivity of the electrodes.

### DISCLOSURE OF THE INVENTION

As a solution to the aforementioned subject, a method of fabricating a solar cell of this invention is such as fabricating a solar cell configured so that a plurality of parallel grooves are formed on a first main surface of a semiconductor single crystal substrate, in each of the groove the inner side face on one side as viewed in the width-wise direction thereof is used as an electrode-forming area where a metal electrode for cell output is formed, wherein the metal electrode is formed by first forming a metal-containing underlying layer on the electrode-forming area, and then by forming on the metal-containing underlying layer a main electrode metal layer containing at least any one of an electroless-plated layer, electroplated layer and hot-dipped layer.

A solar cell of this invention is such as being configured so that a plurality of parallel grooves are formed on a first main surface of a semiconductor single crystal substrate, in each of the groove the inner side face on one side as viewed in the width-wise direction thereof is used as an electrode-forming area, where a metal electrode for cell output is formed, wherein the metal electrode comprises a metal-containing underlying layer in contact with the semiconductor single crystal substrate, and a main electrode metal layer formed on the metal-containing underlying layer.

In this invention, formation of the main electrode metal layer is formed by using at least any one of an electroless-plated layer, electroplated layer and hot-dipped layer. This ensures operations and effects listed below:
(1) the electrode can be thickened as compared with the case where the electrode is formed solely by vapor deposition, and this successfully lowers resistivity of the electrode and consequently increases the output;
(2) formation of the main electrode metal layer without involving vapor phase, unlike vapor deposition, successfully reduces number of times of apparatus cleaning, facilitates the maintenance, and consequently raises the productivity; and
(3) time required for forming the main electrode metal layer can be shortened, and this raises the productivity.

In the solar cell of this invention, the main electrode metal layer is not formed directly on the non-metallic semiconductor single crystal substrate, but instead on the metal-containing underlying layer, to thereby ensure the adhesiveness of the layer to a level equivalent to or superior to that obtainable by vapor deposition, to thereby ensure adhesiveness of the metal electrode for output extraction to a sufficient level despite of its large thickness, and to thereby effectively reduce resistivity of the electrode.

The metal-containing underlying layer can be formed as a metal-deposited layer thinner than the main electrode metal layer. In this case, the metal-containing underlying layer can readily be formed by the oblique-angled vapor deposition on the inner side face of each groove on one side as viewed in the width-wise direction of the groove. Since only a small thickness of deposition will suffice herein, time required for the deposition can considerably be shortened as compared with the case where the entire portion of the electrode is formed by vapor deposition. Although also the conventional OECO solar cell adopted oblique-angled vapor deposition, the deposition inevitably allowed some excessive amount of the deposited layer to be formed also on the top surfaces of the projected ridges located between the grooves on the substrate, and this undesirably required labor-consuming post-processing for the removal. On the contrary, the aforementioned method of this invention requires only deposition of a minimum thickness of the metal-containing underlying layer necessary for enabling formation of the main electrode metal layer by electroless plating, electroplating or hot dipping. Therefore, only an extremely small amount of metal can adhere on the top surface of the projected ridges, where removal of the deposition is very easy or even unnecessary.

The metal-containing underlying layer can be formed as a catalytic functionalized layer. On the surface of the catalytic functionalized layer herein, an electroless-plated layer can be deposited. Electroless plating can be carried out simply by dipping the substrate into a plating bath, and raises almost no problem in maintenance of the apparatus unlike vapor deposition. The electroless plating is also advantageous in that a relatively high layer growth rate can be expected, and in that a plated layer can grow selectively on the metal-containing underlying layer, and this means that the plated layer is less likely to grow on any unintended portions such as on the top surface of the projected ridges. It is thus easy to grow the plated layer to a large thickness selectively on the electrode-forming area. Because the catalytic functionalized layer is only to provide nuclei for depositing the plated layer, it is not necessary to form the layer on the entire surface of the electrode-forming area, where only an extremely small thickness as thin as 10 to 60 Å will suffice. Therefore formation of the catalytic functionalized layer typically by vapor deposition can ensure more distinctive expression of the effects described in the previous paragraphs.

### BRIEF DESCRIPTION OF THE DRAWINGS

Fig. 1 is a schematic view showing an exemplary sectional structure of a solar cell of this invention;
Fig. 2A is an explanatory drawing showing a process step for fabricating the solar cell shown in Fig. 1;
Fig. 2B is an explanatory drawing showing a process step for fabricating the solar cell shown in Fig. 1, as continued from Fig. 2A;
Fig. 2C is an explanatory drawing showing a process step for fabricating the solar cell shown in Fig. 1, as continued from Fig. 2B;
Fig. 2D is an explanatory drawing showing a process step for fabricating the solar cell shown in Fig. 1, as continued from Fig. 2C;
Fig. 2E is an explanatory drawing showing a process step for fabricating the solar cell shown in Fig. 1, as continued from Fig. 2D;
Fig. 2F is an explanatory drawing showing a process step for fabricating the solar cell shown in Fig. 1, as continued from Fig. 2E;
Fig. 2G is an explanatory drawing showing a process step for fabricating the solar cell shown in Fig. 1, as continued from Fig. 2F;
Fig. 2H is an explanatory drawing showing a process step for fabricating the solar cell shown in Fig. 1, as continued from Fig. 2G;
Fig. 3 is a schematic view showing a sectional structure of an essential portion of the solar cell of this invention;
Fig. 4 is a schematic view showing an exemplary method of forming the metal-containing underlying layer by vapor deposition;
Fig. 5 is a conceptual view for explaining layer formation by oblique-angled vapor deposition;
Fig. 6 is a schematic sectional view of the grooves formed on the substrate;
Fig. 7 is a conceptual view for explaining formation of electroless-plated layer on the catalytic functionalized layer;
Fig. 8A is a schematic view of a sectional texture structure of the electroless-plated layer;
Fig. 8B is a schematic view of a sectional texture structure of the electroplated layer;
Fig. 9 is a schematic view of an embodiment in which the electroplated layer is directly formed on the electroless-plated layer;
Fig. 10A is a schematic view of an embodiment in which the electroplated layer is formed directly on the metal-containing underlying layer;
Fig. 10B is a schematic view of an embodiment in which the hot-dipped layer is formed directly on the metal-containing underlying layer; and
Fig. 11 is a perspective view showing an exemplary style of formation of the bus bar electrode in the OECO solar cell.

### BEST MODE FOR CARRYING OUT THE INVENTION

The following paragraphs will describe best modes for carrying out this invention making reference to the attached drawings, where it is to be understood that this invention is by no means limited to these best modes for carrying out the invention. Fig. 1 is an enlarged schematic view showing an exemplary sectional structure of the first main surface 24a side of the solar cell 1 according to one embodiment of this invention. The solar cell 1 is configured so that a large number of grooves 2 of several-hundred-micrometers wide and approx. 100 µm deep are formed in parallel on the first main surface 24a of a p-type silicon single crystal substrate sliced out from a silicon single crystal ingot. These grooves 2 can be carved *en bloc* using a set of hundreds to thousands of concentrically-joined rotary blades which rotate all together, where it is also allowable to divide the carving operation into several numbers of the run.

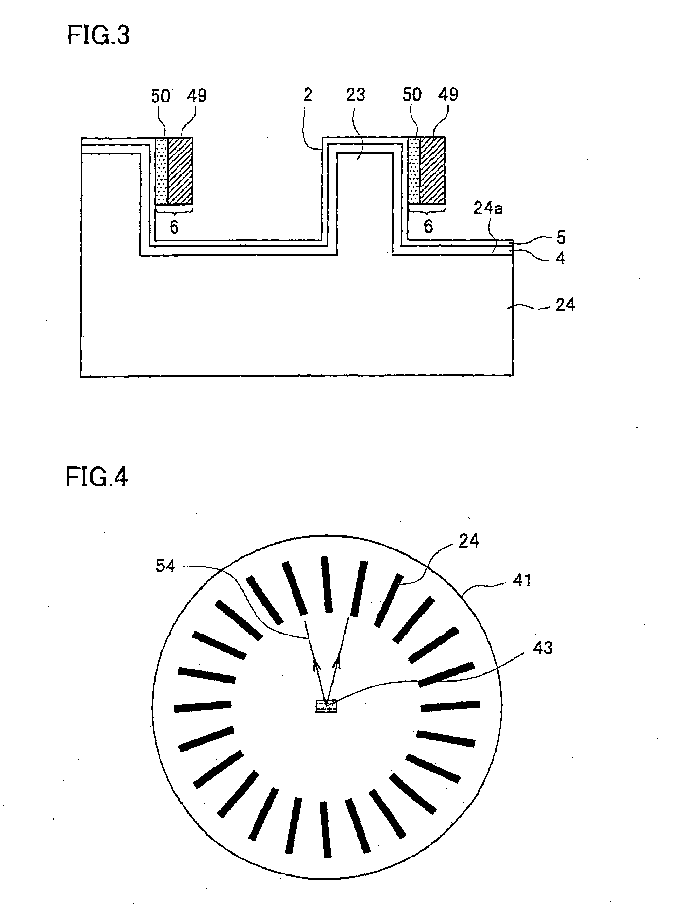

On the first main surface 24a of the substrate having the grooves 2 thus formed thereon, an emitter layer 4 is formed by thermally diffusing phosphorus as an n-type dopant, so as to produce a p-n junction portion. Over the p-n junction, a thin silicon oxide film 5 which functions as a tunnel insulating film is formed typically by the thermal oxidation process. On the silicon oxide film 5 on the inner side face of the individual grooves 2 on one side as viewed in the width-wise direction of the grooves 2, metal electrodes 6 are formed, and the entire portion of the first main surface 24a of the substrate including the metal electrodes 6 is covered by a silicon nitride film 7 which functions as a anti-reflection film. As shown in Fig. 3, the metal electrode 6 comprises a metal-containing underlying layer 50 in contact with the substrate 24 (silicon oxide film 5) and a main electrode metal layer 49 formed on the metal-containing underlying layer 50.

Next paragraphs will describe an exemplary method of fabricating the solar cell 1. First a p-type silicon single crystal ingot, which is prepared by adding a Group III element such as born or gallium to high-purity silicon, is obtained, and p-type silicon single crystal substrates are sliced out from the ingot. The silicon single crystal ingot may be prepared also by the CZ (Czochralski) method or by the FZ (Floating Zone Melting) method. For the case where a polysilicon ingot is used, the ingot may be manufactured by any known crystal producing technologies such as the HEM method, cast method and EFG method.

Specific resistance of the p-type silicon single crystal substrate is preferably around 0.1 to 10 Ωcm, and more preferably 0.5 to 2.0 Ωcm in view of fabricating a solar cell having a high quality. A thickness of the substrate of 50 µm or around may be advantageous considering cost and capability of capturing the incident light within the solar cell, but the thickness is more preferably 150 to 300 µm in order to ensure a sufficient mechanical strength of the substrate against various processing given later.

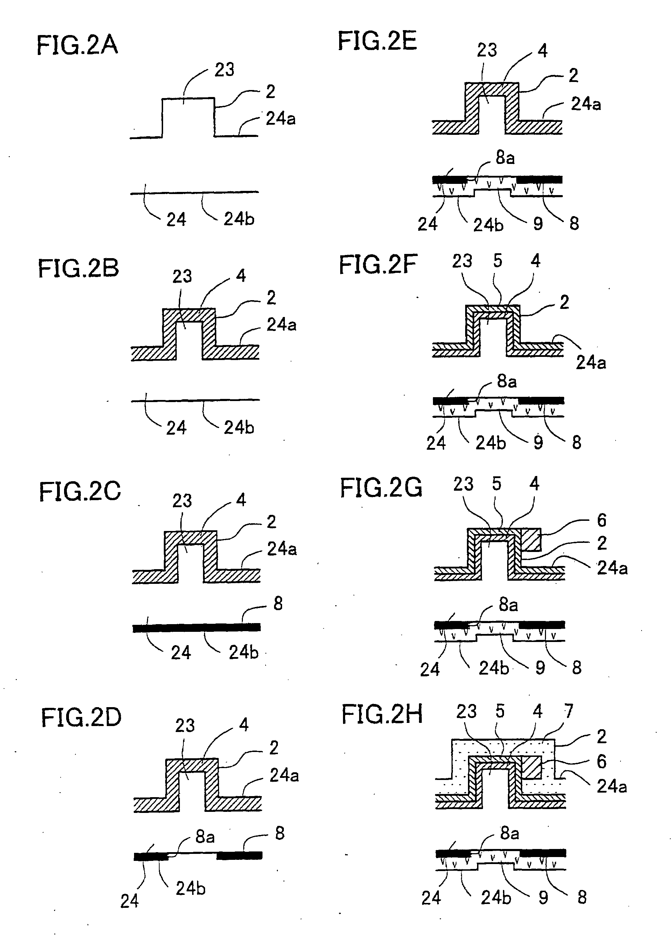

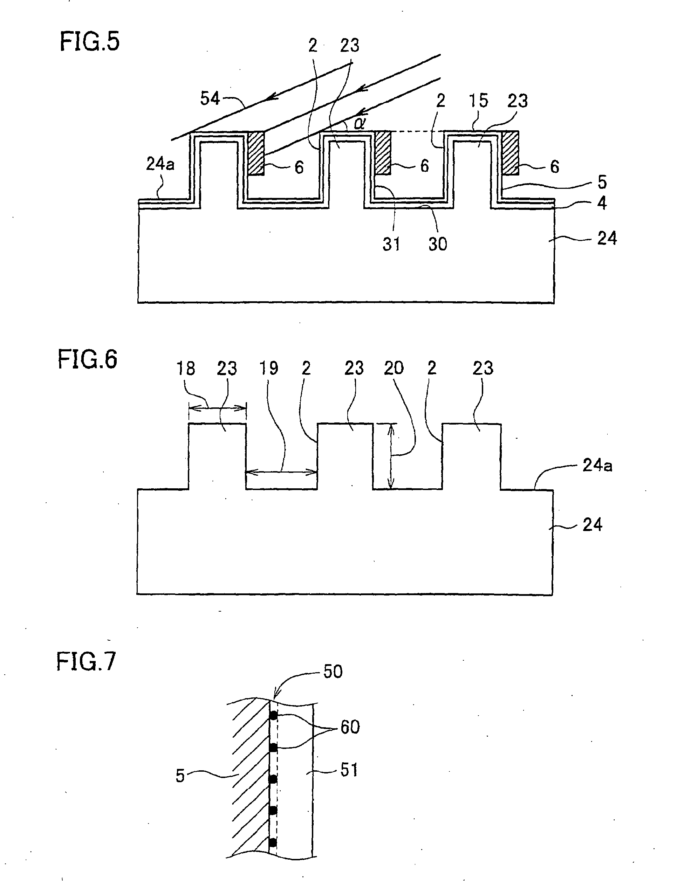

Next as shown in Fig. 2A, a plurality of parallel grooves 2 are formed on the first main surface 24a of the substrate 24 using a high-speed rotary blade, where this process consequently produces projected ridges 23 between the adjacent grooves 2. As shown in Fig. 6, width of the top surface 18 of the projected ridge 23, width of the bottom portion 19 of the groove 2, and height 20 of the projected ridge 23 are determined in relation to the angle of deposition adopted in the later oblique-angled vapor deposition process. Ratio of the width of the top surface 18 and the width of the bottom portion 19 preferably resides within a range from 1:3 to 1:10, for example, and the elevation height preferably falls within a range from 20 to 50 µm in order to ensure a sufficient mechanical strength of the whole substrate. Any damages possibly produced during various processing can be removed if necessary by etching using an etching solution such as acidic or alkaline one.

Next as shown in Fig. 2B, the emitter layer 4 is formed as an n⁺-layer in the surficial portion of the substrate. Methods of forming the emitter layer may be any of the coating diffusion method using diphosphorus pentaoxide, ion implantation method for directly implanting phosphorus ion, and so forth, but a preferable method from the economical viewpoint is the vapor-phase diffusion method using phosphorous oxychloride. In an exemplary process, the n⁺-type emitter layer 4 can be formed by annealing the substrate in a phosphorous oxychloride environment at 850°C or around. Thickness of the emitter layer 4 is preferably 0.5 µm or around, for example, and the dopant is preferably introduced up to a surface impurity concentration so as to adjust the sheet resistance within a range from 40 to 100 Ω/□ or around (typically 100 Ω/□). A phosphorus glass formed in the surficial portion of the substrate during the process is removed in a hydrofluoric acid solution.

Next, electrode is formed on a second main surface 24b side. First, as shown in Fig. 2C, a silicon nitride layer 8 is formed as a passivation film on the second main surface 24b. The silicon nitride layer 8 can be formed by the CVD (Chemical Vapor Deposition) process. Any of the normal-pressure thermal CVD process, reduced-pressure thermal CVD process, photo CVD process and so forth is applicable herein, where the remote plasma CVD process is particularly preferable for this invention, because the process can proceed at lower temperatures ranging from 350 to 400°C or around, and can reduce the surface recombination rate of the silicon nitride layer 8 to be obtained. It is to be noted that the direct thermal nitridation method is not preferable because the process cannot afford a sufficient thickness of the obtainable layer.

Next as shown in Fig. 2D, grooves 8a for electrode connection are formed in thus-formed silicon nitride layer 8 so as to reach the underlying p-type silicon single crystal substrate 24 using a high-speed rotary blade. After the grooves 8a are thus formed, an electrode 9 is then formed so as to cover the grooves 8a together with the peripheral silicon nitride layer 8 as shown in Fig. 2E. Although silver or copper is available as the electrode material herein, aluminum (including alloys thereof) is most preferable in view of economy and workability. Aluminum can be deposited by either method of sputtering and vapor deposition. All processes for forming the electrode on the second main surface 24b side thus complete.

Next as shown in Fig. 2F, the silicon oxide film 5 is formed on the first main surface 24a by the thermal oxidation method. The silicon oxide film 5 is disposed between the substrate 24 and the electrode 6, and through which photogenerated carriers are extracted in a form of tunnel current from the substrate 24 to the electrode 6. This method is advantageous in preventing the energy conversion efficiency from being degraded due to recombination of the carriers, because the semiconductor substrate 24 does not directly contact with the electrode 6, thus the interface state decreases. Thickness of the silicon oxide film 5 is selected within a range from 5 to 30 Å in order to optimize the tunneling effect while avoiding short-circuiting. The silicon oxide film 5 can be formed by any known methods including dry oxidation, wet oxidation, steam oxidation, pyrogenic oxidation, hydrochloric acid oxidation and so forth, and among others, dry oxidation is preferably adopted since the method can ensure a high film quality and easy control of the thickness, where thermal oxidation at 500°C for 30 minutes or around, for example, results in formation of the silicon oxide film 5 having the above-described thickness.

On the substrate 24 having the silicon oxide film 5 already formed thereon, the electrode 6 is formed on the inner side face (electrode-forming area) of the groove 2 on one side as viewed in the width-wise direction of the groove 2. The formation of the electrode 6 begins with formation of the metal-containing underlying layer 50 (Fig.3). The metal-containing underlying layer 50 can be formed as a metal deposited layer. In the deposition, the metal-containing underlying layer 50 can selectively be formed on the inner side face of the groove 2 on one side by oblique-angled vapor deposition similarly to as being adopted for the conventional OECO solar cell. By forming the metal-containing underlying layer 50 as a metal deposited film thinner than the main electrode metal layer 49 herein, the deposition time can be shortened as compared with the case where the entire portion of the electrode 6 is formed by vapor deposition. In particular as for electron beam deposition, the electron beam irradiated to the semiconductor substrate may degrade properties of the substrate during the deposition, and may sometimes require annealing under a hydrogen atmosphere after a silicon nitride film is deposited in the later process. In contrast, the invention can shorten the deposition time, and can consequently reduce the damage to the substrate 24.

More specifically, as shown in Fig.7, the metal-containing underlying layer 50 can be formed as a catalytic functionalized layer first, and then on the surface thereof, an electroless-plated layer 51 (which composes entire portion or a part of the main electrode metal layer 49) can be deposited. In the electroless plating for the surface of the silicon oxide film 5 that is an insulating material, it is necessary to give catalytic activity to the surface to be plated. The catalytic activation is necessary for starting the plating, and is effected in the pretreatment stage to the surface to be plated, rather than adding a catalyst to the plating bath. Deposition reaction of plating metal in electroless plating is generally considered as of autocatalytic, and is sometimes referred to as "autocatalytic plating" based on the fact that the plating metal first deposits on the catalytic functionalized surface, and the metal continuously deposits thereon while being assisted by the catalytic function of the plating metal *per se.*

Vapor deposition method available herein may be either of physical vapor deposition (PVD) methods such as thermal vapor deposition methods (resistance-heating deposition, electron-beam deposition, laser deposition), ion plating, ion-beam deposition, cluster ion-beam deposition, liquidous charged-particle-beam deposition, electric field deposition, and ion beam sputtering deposition. Degree of vacuum herein is preferably set to 10⁻⁴ Pa or below, where the higher the better.

One exemplary oblique-angled vacuum deposition method for depositing a metal is shown in Fig.4 where substrates 24, having grooves 2 (Fig.1) already formed on the main surface thereof, are radially disposed using holders or the like in a vacuum vessel 41 having a cylindrical drum form, so as to be opposed with an evaporation source 43. The substrates 24 herein are set as being inclined as shown in Fig. 5 so that advancing direction 54 (indicated by arrows) of the evaporated particles is kept at an angle α of 1 to 30° or around inclined away from the top surface 15 of the projected ridges 23. This allows the projected ridges 23 to mask the bottom portions 30 of the grooves 2, and thus prevents the evaporated particles from adhering on the bottom portions 30. Since the angle of inclinati-on in the vapor deposition is small, the evaporated particles hardly adhere on the top surfaces 15, and consequently the metal deposits on the inner side faces 31 on one side opposing the evaporation source. It is not always necessary for the evaporation apparatus to have the cylindrical drum form, and may have any form provided that it can hold the substrates 24 as being inclined by the aforementioned angle α away from the advancing direction of the evaporated particles. The evaporated particles from the evaporation source 43 (metal for catalytic functionalization) advance straightly in all directions centered round the source.

There are no special limitations on the metals to be deposited as the catalytic functionalized layer provided that they can give catalytic activity to the surface to be plated, where preferable examples include palladium and platinum having a high catalytic activity. The metal-containing underlying layer 50 to be formed in this case will be such as those containing a metal mainly composed of palladium or platinum. Other available examples include iron, nickel and so forth, although they have only smaller catalytic activities as compared to those of palladium or platinum. Thickness of the deposited film may be extremely thin as far as it can allow the electroless plating to proceed, and generally adjusted within a range from 10 to 60 Å (1 to 6 nm), and more preferably 10 to 30 Å (1 to 3 nm). In other words, if catalytic metal particles 60 once adhere in a distributed manner at an appropriate density, the electroless-plated layer can grow using these particles as deposition nuclei.

Next, the metal (e.g., palladium) for forming the catalytic functionalized layer adhered on the top surface 15 of the projected ridges 23 is chemically removed using hydrochloric acid, concentrated sulfuric acid, concentrated nitric acid, phosphoric acid or the like. Because the metal for forming the catalytic functionalized layer adhered on the top surface 15 amounts extremely small as compared with the amount of adhesion on the inner side face of the groove, the metal on the top surface can completely be removed at first even under simultaneous etching of the whole portion, to thereby leave the catalytic functionalized layer only on the inner side face of the groove. This process is thus successful in obtaining a status in which the catalytic functionalized layer 50 is predominantly adhered only on the inner side face of the groove 2.

The process is followed by electroless plating to be proceeded on thus-obtained catalytic functionalized layer. The electroless plating refers to a method by which metal plating is proceeded on the electrode-forming surface based on chemical substitution and reductive operation between metals, without relying upon electrolytic reduction using electric current, and can be proceeded by any known methods. Electroless plating bath may be any publicly-known ones. The bath is generally composed of salt of metal to be plated, reducing agent, complexing agent, buffering agent, stabilizer and the others (e.g., pH adjustor, surfactant). Metals to be deposited on the substrate through the electroless plating are typified by copper, silver, chromium and nickel (or any alloys mainly composed of any of these metals).

Methods and compositions of the electroless plating are publicly known in this industrial field, and a variety of plating bath containing copper, nickel or cobalt are commercially available. Also a variety of alloys such as copper-nickel alloy, or alloy of metal with other elements such as phosphorus and boron can be plated in an electroless manner. Preferable examples of metals for electroless plating in this invention include copper, silver and nickel. While the following description will be made on nickel as a representative metal for the electroless plating, it is to be understood that copper and silver can similarly be plated by the electroless plating using the publicly known techniques. A disadvantage of silver resides in its high cost, and that of copper resides in its slightly lower corrosion resistance. Nickel can produce an electroless-plated layer allowing corrosion resistance and cost well balanced.

The plating bath used for the electroless nickel plating is generally composed of four components dissolved in water. The components are (1) a metal ion source, such as sulfate of nickel; (2) a reducing agent, such as hypophosphites, dimethylamineborane; (3) a pH adjustor, such as organic acids; and (4) a complexing agent acting against at least one metal used for thoroughly preventing the metal from precipitating from the bath. Beside the above components, a stabilizer or the like can be included in the electroless nickel plating bath.

Examples of the nickel salts include nickel chloride, nickel sulfate, nickel acetate and nickel carbonate. Examples of the reducing agent include (1) phosphorus compounds, such as sodium hypophosphite, potassium hypophosphite and nickel hypophosphite; and (2) boron compounds, such as dimethylaminoborane, diethylaminoborane, and sodium boron hydride. Compositional ratio of the nickel salt, phosphorus compound and boron compound can properly be adjusted depending on a desirable composition of the plated film. Also concentrations of the individual components can properly be determined based on consideration on stability of the bath or deposition rate, where it is generally preferable to adjust the nickel salt concentration to 15 g/litter to 30 g/litter. It is to be noted that the obtained electroless-plated nickel layer inevitably contains phosphorus or boron component ascribable to the above-described reducing agent, which is a specific feature of the electroless-plated nickel layer.

It is also allowable to add a complexing agent to the plating bath considering the stability or pH buffering action, where examples of the agent include organic acids such as acetic acid, malic acid and citiric acid; and ethylenediamine tetraacetate. It is still also allowable to add a stabilizer to the plating bath in order to prevent the nickel compound from depositing after autodecomposition, where examples of the stabilizer include a trace amount of lead nitrate, bismuth nitrate, antimony salts and sulfur compounds. pH of the plating bath is adjusted within a range from 6 to 7 considering stability of the bath, deposition rate and so forth.

The electroless-plated film can be formed by dipping the catalytic functionalized layer 50 on the substrate 24 in the aforementioned plating bath for a predetermined duration of time. Temperature of the plating bath can be determined considering stability of the bath, deposition rate and so forth, where it is preferably adjusted within a typical range from 60 to 95°C, and more preferably from 70 to 90°C. Thickness of the plated film can be adjusted by adjusting the dipping time in the plating bath. Thickness of the plated film obtained in this invention is preferably adjusted within a range from 1 to 50 µm so as to attain a resistivity as low as suitable enough for the electrode, and so as to reduce the shadowing loss ascribable to the electrode, and more preferably 3 to 10 µm.

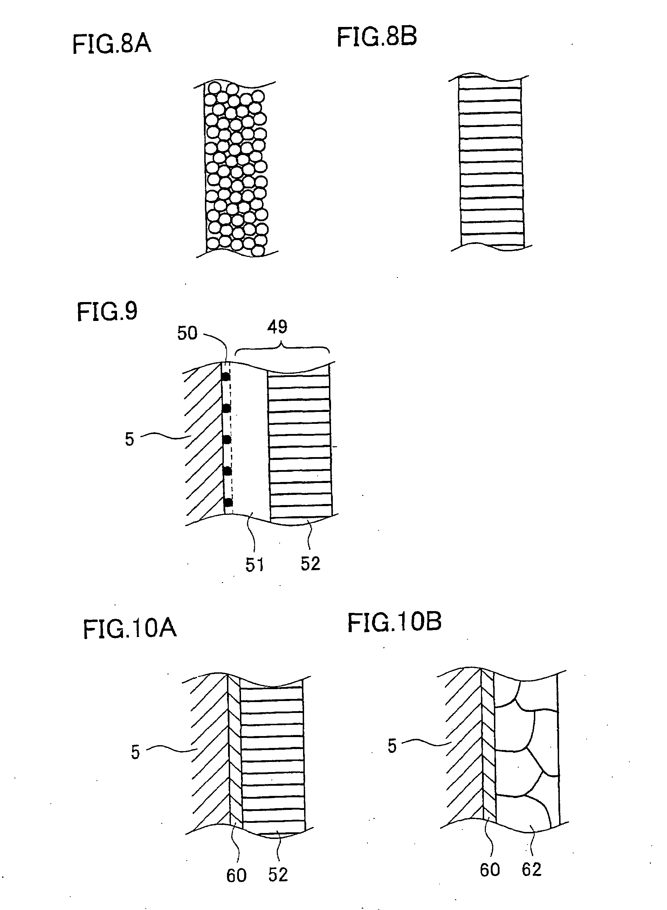

As described in the above, the electroless-plated nickel film can selectively be formed on the inner side face of the groove 2 on one side as viewed in the width-wise direction of the groove 2. For the case where the electroless-plated nickel film is used as the main electrode metal layer 51 without any modification as shown in Fig.7, the main electrode metal layer 51 is obtained as a metal layer having nickel as a major component (it is to be noted that the "major component" in the context of this specification means a component contained at a largest content ratio). Because the electroless-plated layer deposits and grows while producing nuclei in an autocatalytic manner as described in the above, the obtained film may sometimes have an isometric texture structure composed of very fine crystal grains as shown in Fig. 8A, or may have an amorphous structure. The electroless-plated layer having these structures generally tends to show a high resistivity. Annealing of the plated film is then successful in accelerating crystallization or crystal grain growth of the plated film, and in obtaining the electrode having a lower resistance. The crystal grain growth herein is preferably proceeded so as to attain an average grain size of the crystal grain of 0.5 to 10 µm or around. Temperature of the annealing can typically be set within a range from 150 to 400°C, and more preferably 200 to 350°C. Annealing time is appropriately selected within a range from 15 to 120 minutes in general. Available atmosphere for the annealing may be air, inert gas, reductive gas or the like, and can properly be selected taking the workability, cost and so forth into consideration.

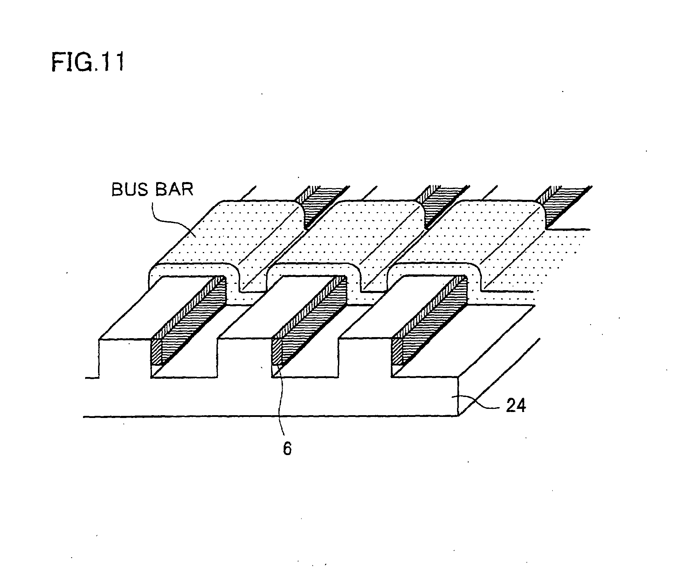

According to the process steps described in the above, the electrode 6 is formed as shown in Fig.2G. Thereafter, a bus bar electrode as shown in Fig.11 is formed so as to cross each electrode 6 formed in the groove 2 based on any publicly-known procedures, and further thereon the silicon nitride layer 7, which serves as a film for surface passivation and anti-reflection, is uniformly deposited on the first main surface 24a, to thereby obtain a final form of the solar cell 1. The silicon nitride layer 7 can be formed by any publicly known methods such as plasma CVD, catalytic CVD (also referred to as "Hot-Wire CVD"), and thermal CVD. Thickness of the layer is determined so as to attain a maximum anti-reflection effect based on refractive index of the film to be deposited. In general, solar cell is modularized by molding with an organic resin such as EVA (ethylene vinyl acetate) or the like under a glass having a refractive index of 1.5. Considering the above, the thickness of the silicon nitride film, assumed as having a refractive index of 2.0, preferably has a thickness of 600 to 700 Å (60 to 70 nm).

It is also allowable now, as shown in Fig. 9, to form the electroless-plated layer (e.g., electroless-plated nickel layer) 51 on the metal-containing underlying layer (e.g., the aforementioned catalytic functionalized layer) 50, and to form a electroplated layer (e.g., electroplated nickel layer) 52 on the electroless-plated layer 51, to thereby form the main electrode metal layer 49 which comprises the electroless-plated layer 51 and electroplated layer 52.

The electroplated layer 52 can be grown at a high speed, and is thus advantageous in thickening the electrode and raising production efficiency. The electroplated nickel layer is readily obtained so as to have a sectional texture, as shown in Fig. 8B, in which columnar crystal grains are grown in the thickness-wise direction. This contributes to reduction in resistivity in the thickness-wise direction. From another viewpoint, the electrode 6 is not so strictly required to have excellent outer appearance such as smoothening or glossing of the plated layer. This desirably reduces amount of addition of any additives to the electroplating bath, and as a consequence considerably raises content of the metal as a major component. This is also effective enough to contribute to reduction in resistivity of the electrode.

Electroplating herein can be proceeded by a general static plating method in which electroless-plated-layer forming side of the substrate and a plating electrode are opposed in the plating bath. The plating current is supplied to the electroless-plated layers 51 formed on the inner side faces of the grooves 2 through a bus bar electrode (or a metal layer later patterned to produce a part thereof, formed by vapor deposition or the like), although not shown, preliminarily formed so as to connect to these layers.

It is to be noted that the electroplated layer 52 can be formed directly on the metal-containing underlying layer 60 if the metal-containing underlying layer 60 is formed so as to cover the underlying layer (silicon oxide film 5) at a sufficiently large coverage ratio (for example, in a thickness of 0. 05 to 1.0 µm, ratio of covered area of 80% or more) as shown in Fig. 10A, rather than the catalytic functionalized layer 50 having a smaller coverage ratio as shown in Fig. 9. It is still also allowable to form a hot-dipped metal layer 62 composed of a solder alloy (e.g., Pb-Sn solder alloy), or any other low-melting-point alloys having a melting point of 500°C or below as shown in Fig.10B, in place of the electroplated layer 52. Either method is advantageous in omitting formation of the electroless-plated layer, and in readily thickening the electrode.

### (Examples)

This invention will further be detailed referring to specific examples, where it is to be understood that this invention is by no means limited by the examples. The process began with formation of a great number of parallel grooves 2, as shown in Fig. 6, on the first main surface of a (100) p-type CZ silicon single crystal having a diameter of 150 mm, resistivity of 1.0 Ωcm and thickness of 250 µm, using a commercial dicer. Width of the top surface 18 of the projected ridge 23 herein was adjusted to 100 µm, width of the bottom portion 19 of the groove 2 to 400 µm, and height 20 of the projected ridge 23 to 50 µm. After the groove formation, the substrate was etched using a mixed solution of hydrofluoric acid and nitric acid to thereby remove any damage produced therein.

Next, phosphorus was diffused into the processed surface to thereby form the emitter layer comprising an n⁺-layer. Process conditions were 850°C and 30 minutes, and sheet resistance of the obtained emitter layer was measured as 100 Ω/□. The silicon oxide film was then formed on the entire surface. Process conditions were 500°C and 15 minutes, and thickness of the obtained film was found to be 15Å (1.5 nm) when measured by ellipsometry.

Next, the semiconductor substrate was set 680 mm away from an evaporation source, which was palladium herein, at an angle of incidence α of 6°, and electron beam deposition was carried out at a degree of vacuum of 2.2 × 10⁻⁵ Pa so as to attain a film thickness of 30 Å (3.0 nm), to thereby form the catalytic functionalized layer. Time required for the deposition was 5 seconds excluding those for vacuum operations before and after the deposition. After removal of palladium deposited on the top surface of the projected ridges with hydrochloric acid, the substrate was subjected to pre-cleaning using a 10 vol% aqueous sulfuric acid solution, and thereon an electroless-plated, Ni-B plated film of 5 µm thick was formed using an electrtoless Ni-B plating bath (product of Japan Kanigen Co., Ltd., S-753) at 80°C for 30 minutes.

Next, the silicon nitride film having a refractive index of 2.0 was formed to a thickness of 700 Å (70 nm) by plasma CVD. Thereafter the bus bar electrode was formed using a conductive paste (Example 1).

Next, a silicon single crystal substrate same as that used in the above was subjected to the same processes up to the formation of the silicon oxide film. The semiconductor substrate was then set 680 mm away from an evaporation source and at an angle of incidence α of 6°, and electron beam deposition was carried out at a degree of vacuum of 2.2×10⁻⁵ Pa so as to allow indium to deposit to a thickness of 0.4 µm, to thereby form the metal-containing underlying layers. Time required for the deposition was 5 minutes excluding those for vacuum operations before and after the deposition. After removal of indium deposited on the top surface of the projected ridges with hydrochloric acid, the bus bar electrode as shown in Fig. 11 was formed using a conductive paste. Next, the substrate was subjected to pretreatment using a 10 vol% aqueous sulfuric acid solution, and further subjected to plating in an electrolytic Ag plating bath at a bath temperature of 25 to 30°C, current density of 0.1 A/dm² for 25 minutes, so as to form an electrolytic Ag plated film of approx. 5 µm thick on the metal-containing underlying layer in the grooves, to thereby produce the electrodes (Example 2). Current supply to the metal-containing underlying layers during the electroplating was effected through the bus bar electrode.

For comparison, a solar cell having the same specification described in the above, except that the electrodes were formed by the conventional OECO process (aluminum vapor deposition, 5 µm thick) was also fabricated. These solar cell samples were subjected to performance evaluation tests. More specifically, the solar cells were assembled up to obtain solar cell units having a light-receiving area of 10 cm square, and then subjected to measurement of current-voltage characteristics at 25°C using a solar simulator (light intensity: 1 kW/m², spectrum: AM1.5 global). Various characteristics of the solar cells obtained from the current-voltage characteristic curves and time required for the deposition were listed by the individual samples in Table 1.

**Table 1**

| | Short-circuiting current density Jsc (mA/cm²) | Open-circuit voltage density Voc (mV/cm²) | Fill factor (curve factor) FF | Conversion efficiency η (%) | Deposition time |
|---|---|---|---|---|---|
| Example 1 | 38.5 | 652 | 81.5 | 20.5 | 5 sec |
| Example 2 | 38.7 | 650 | 81.0 | 20.3 | 5 min |
| Comparative Example | 38.8 | 650 | 76.1 | 19.2 | 55 min |

The results suggests the followings:
(1) Examples of this invention were successful in fabricating the solar cells having higher conversion efficiencies within shorter deposition times;
(2) the shadowing loss of the solar cells of this invention were found to have a shadowing loss of 5%, which was decreased by 3% from that of the cell in which the electrodes were formed by screen printing (8%);
(3) cleaning of the inner portion and areas around the deposition source of the vapor deposition apparatus only at a frequency of once in a half-year or a whole year may be sufficient in this invention, in contrast to the conventional OECO process which has required the cleaning once in every three days under normal operational conditions, and consequently, the cost of maintenance can be decreased; and
(4) while electron beam deposition was adopted in the above Examples, desirable performances were successfully obtained even if the annealing under a hydrogen atmosphere was omitted after the deposition of the silicon nitride film. On the other hand, Comparative Example failed in obtaining desirable performances unless the annealing under a hydrogen atmosphere was carried out, and equivalent performances were obtained only after the annealing at 400°C for 30 minutes.

## Claims

1. A method of fabricating a solar cell configured so that a plurality of parallel grooves are formed on a first main surface of a semiconductor single crystal substrate, in each of the groove the inner side face on one side as viewed in the width-wise direction thereof is used as an electrode-forming area where a metal electrode for cell output is formed, wherein the metal electrode is formed by first forming a metal-containing underlying layer on the electrode-forming area, and then by forming on the metal - containing underlying layer a main electrode metal layer containing at least any one of an electroless-plated layer, electroplated layer and hot-dipped layer.

2. The method of fabricating a solar cell as claimed in Claim 1, wherein the metal-containing underlying layer is formed as a metal deposited layer thinner than the main electrode metal layer.

3. The method of fabricating a solar cell as claimed in Claim 1 or 2, wherein the metal-containing underlying layer is a catalytic functionalized layer, and the electroless-plated layer is deposited on the catalytic functionalized layer.

4. The method of fabricating a solar cell as claimed in Claim 3, wherein a metal composing the catalytic functionalized layer is mainly composed of palladium or platinum.

5. The method of fabricating a solar cell as claimed in any one of Claims 1 to 4, wherein the electroless-plated layer is formed on the metal-containing underlying layer, and on the electroless-plated layer an electroplated layer is formed.

6. The method of fabricating a solar cell as claimed in Claim 1 or 2, wherein the electroplated layer is directly formed on the metal-containing underlying layer.

7. The method of fabricating a solar cell as claimed in any one of Claims 1 to 6, wherein the main electrode metal layer is a metal layer mainly composed of nickel.

8. A solar cell configured so that a plurality of parallel grooves are formed on a first main surface of a semiconductor single crystal substrate, in each of the groove the inner side face on one side as viewed in the width-wise direction thereof is used as an electrode-forming area, where a metal electrode for cell output is formed, wherein the metal electrode comprises a metal-containing underlying layer in contact with the semiconductor single crystal substrate, and a main electrode metal layer formed on the metal-containing underlying layer.

9. The solar cell as claimed in Claim 8, wherein the main electrode metal layer contains at least any one of an electroless-plated layer, electroplated layer and hot-dipped layer.

10. The solar cell as claimed in Claim 8 or 9, wherein the main electrode metal layer is a metal layer mainly composed of nickel.

11. The solar cell as claimed in any one of Claims 8 to 10, wherein the metal-containing underlying layer contains a metal mainly composed of palladium or platinum.
